# EUROPÄISCHE PATENTSCHRIFT

(11) **EP 1 892 650 B1**
(45) Veröffentlichungstag und Bekanntmachung des Hinweises auf die Patenterteilung: **27.01.2010**
(21) Anmeldenummer: 07015140.2
(22) Anmeldetag: 02.08.2007
(51) Int. Cl.: G01R 31/01, H01Q 1/22, G06K 19/07

(54) **Verfahren zum kontaktlosen Testen von auf einer Materialbahn aufgebrachten Antenne**
Method for contactless testing of an antenna mounted on a sheet of material
Procédé de test sans contact d'une antenne installée sur un rouleau de papier

(30) Priorität: 26.08.2006 DE 102006040180
(43) Veröffentlichungstag der Anmeldung: 27.02.2008
(73) Patentinhaber: Nordenia Deutschland Gronau GmbH, 48599 Gronau (DE)
(72) Erfinder: Kohla, Michael, 48329 Havixbeck (DE)
(74) Vertreter: Albrecht, Rainer Harald

(56) Entgegenhaltungen:
- EP-A1- 1 522 956
- DE-A1- 10 117 249
- US-A- 6 104 291
- US-A- 6 147 662
- US-A1- 2004 160 233
- US-A1- 2006 038 687
- RITAMÄKI M ET AL: "Contactless radiation pattern measurement method for UHF RFID transponders" ELECTRONICS LETTERS, IEE STEVENAGE, GB, Bd. 41, Nr. 13, 23. Juni 2005 (2005-06-23), Seiten 723-724, XP006024664 ISSN: 0013-5194

## Beschreibung

Die Erfindung betrifft ein Verfahren zum kontaktlosen Testen von auf einer Materialbahn aufgebrachten Antennen für RFID-Etiketten. RFID-Etiketten weisen neben einer Antenne einen RFID-Chip als aktiven oder passiven Schaltkreis auf und sind beispielsweise zur Kennzeichnung von Gegenständen aller Art wie Waren und Transportverpackungen geeignet. Insbesondere bei der Kennzeichnung der Verpackung von Massenartikeln ist üblicherweise nur eine einmalige Verwendung eines RFID-Etikettes vorgesehen, so dass dabei besonders geringe Fertigungskosten gefordert werden.

Die Druckschrift US 6 147 662 beschreibt ein Verfahren zur Herstellung von RFID-Etiketten, wobei eine Antenne mit leitfähiger Tinte oder mit leitfähigem Toner auf eine Materialbahn aufgedruckt wird und wobei nachfolgend ein RFID-Chip auf die Antenne aufgesetzt und mit dieser kontaktiert wird. Die RFID-Etiketten werden vor einem Aufwickeln auf eine Rolle einer Messeinrichtung zugeführt, wobei defekte RFID-Etiketten ermittelt und markiert werden. Insbesondere bei RFID-Etiketten, die bei einer Frequenz im UHF-Bereich (300 MHz bis 3000 MHz) betrieben werden, ist aufgrund der üblicherweise feinen Strukturen mit einem hohen Ausschuss zu rechnen. Durch einen hohen Ausschuss werden die Produktionskosten stark erhöht, da die gesamten RFID-Etiketten mit Antenne und RFID-Chip auszusortieren und zu entsorgen sind.

Die Druckschrift US 2006/0038687 A1 betrifft ein Verfahren zum kontaktlosen Testen von RFID-Etiketten, welche in Form einer Materialbahn vorliegen. Die RFID-Etiketten werden dabei einer Messeinrichtung zugeführt, welche die einzelnen RFID-Etiketten ausliest. Falls die Kommunikation mit einem RFID-Etikett fehlschlägt, wird dieses aussortiert. Dazu kann vorgesehen sein, das entsprechende Etikett zunächst zu markieren.

Aus der Druckschrift DE 101 17 249 A1 ist ein Verfahren zum Testen einer Vielzahl von Spulen bekannt, wobei mittels eines Signalgenerators und einer Antenne ein elektromagnetisches Feld erzeugt wird, in dessen Einflussbereich die zu prüfenden Antennenspulen gebracht werden und wobei mit einer zweiten Antenne und einem angeschlossenen Signaldetektor die von der Antennenspule bewirkte Veränderung des Hochfrequenzfeldes gemessen und ausgewertet werden.

Vor diesem Hintergrund liegt der Erfindung die Aufgabe zugrunde, eine effiziente Prüfung von auf einer Materialbahn aufgebrachten Dipolantennen für RFID-Ettiketten zu ermöglichen und die Kosten bei der Herstellung von RFID-Etiketten zu reduzieren.

Die Aufgabe wird erfindungsgemäß durch ein Verfahren gemäß Patentanspruch 1 gelöst. Erfindungsgemäß erfolgt die Überprüfung der Antennen, bevor diese mit einem RFID-Chip kontaktiert werden, wobei defekte Antennen, die auszusortieren sind, nicht mit einem RFID-Chip versehen werden. Des Weiteren kann auch bei der Fertigung von Antennen für RFID-Etiketten eine Erhöhung der Ausschussquote direkt erkannt werden, worauf das Herstellungsverfahren angepasst oder unterbrochen werden kann.

Erfindungsgemäß wird die Messantennenanordnung der Messeinrichtung mit einem Hochfrequenzsignal des Senders beaufschlagt, wobei ein Teil der Hochfrequenzleistung von der Messantennenanordnung abgestrahlt und von der zu testenden Antenne absorbiert wird. Die Frequenz fₘₑₛₛ des Senders wird dabei zweckmäßigerweise so gewählt, dass die zu testenden Antennen, die innerhalb vorgegebener Herstellungstoleranzen liegen, ein Maximum der Hochfrequenzleistung absorbieren, wodurch auch das an dem Anschluss der Messantennenanordnung zurücklaufende Hochfrequenzsignal S_{rück} minimiert wird. Um einerseits die Leistung, die dem hinlaufenden Hochfrequenzsignal Sₘₑₛₛ und andererseits die Leistung die dem rücklaufenden Hochfrequenzsignal S_{rück} zugeordnet ist, zu bestimmen, ist in einer bevorzugten Ausführungsform der Erfindung vorgesehen, dass das Hochfrequenzsignal Sₘₑₛₛ von dem Sender über einen Richtkoppler zu der Messantennenanordnung geführt wird, wobei der Richtkoppler ein erstes Messsignal ausgibt, das proportional zu der Hochfrequenzleistung Pᵥₒᵣ ist, die zu der Messantennenanordnung hinläuft, und wobei der Richtkoppler ein zweites Messsignal ausgibt, das proportional zu der von der Messantennenanordnung reflektierten Hochfrequenzleistung P_{rück} ist. Das Verhältnis der an dem Sender eingespeisten Leistung zu der von der Messanordnung zurück reflektierten Leistung wird in der Praxis auch als Rückflussdämpfung in Dezibel (dB) angegeben.

Das erfindungsgemäße Verfahren ist zum Testen von Antennen vorgesehen, die als Dipolantennen aus zwei Leiterbahnen mit jeweils einem Anschlussende gebildet sind. Ausgehend von den mittigen Anschlussenden erstrecken sich die in etwa gleich langen Leiterbahnen voneinander weg, wobei die Arbeitsfrequenz f_{A} der Antenne durch ihre Gesamtlänge, die etwa der halben Wellenlänge entspricht, bestimmt ist. Zum Testen dieser Dipolantennen ist für jede der Leiterbahnen eine separate Messantenne der Messantennenanordnung vorgesehen, wobei die Messantennenanordnung mit einem Hochfrequenzsignal Sₘₑₛₛ beaufschlagt wird, dessen Frequenz fₘₑₛₛ etwa dem doppelten der Arbeitsfrequenz f_{A} entspricht. Die Frequenz fₘₑₛₛ entspricht dabei der Resonanzfrequenz, die jeweils für die einzelnen Leiterbahnen zu erwarten ist. Sofern die Leiterbahn keine Defekte, beispielsweise in Form von Unterbrechungen, aufweist, wird der Messantenne aufgrund der Resonanz ein Maximum an Energie entzogen, wodurch auch das von der Messantenne auf der Anschlussleitung zurücklaufende Hochfrequenzsignal S_{rück} reduziert wird. Bei einer defekten Leiterbahn liegt keine Resonanz bei der Frequenz fₘₑₛₛ vor, so dass der Anteil der zurücklaufenden Hochfrequenzleistung P_{rück} vergleichsweise groß ist. Durch die Bestimmung des zurücklaufenden Hochfrequenzsignals S_{rück}, beispielsweise durch einen Richtkoppler und durch eine nachgeschaltete Verstärker/Auswerte-Logik kann dabei aus der Rückflussdämpfung für jede einzelne Antenne die Einhaltung von Herstellertoleranzen bestimmt werden. Um mögliche Kurzschlüsse im Bereich der Anschlussenden zu ermitteln, wird nach dem gleichen Messprinzip die Messantennenanordnung mit der vorgegebenen Arbeitsfrequenz f_{A} beaufschlagt. Im Kurzschlussfall kommt es im Vergleich zu einer funktionsfähigen Antenne zu einem starken Anstieg der reflektierten Hochfrequenzleistung.

Das erfindungsgemäße Verfahren ist insbesondere für Antennen geeignet, deren Arbeitsfrequenz im UHF-Bereich liegt, da bei diesen Antennen aufgrund der feinen Strukturen, insbesondere bei der Massenfertigung durch ein Druckverfahren, beispielsweise ein Tiefdruckverfahren, mit einem erhöhten Ausschuss zu rechnen ist.

Aufgrund der kontaktlosen Prüfung der Antennen kann ein sehr hoher Durchsatz erreicht werden. So wird die Materialbahn in einer bevorzugten Ausführung der Erfindung mit einer mittleren Bahngeschwindigkeit von mehr als 0,8 m/s, vorzugsweise mehr als 1,6 m/s, an der Messeinrichtung vorbeigeführt. Die einzelnen Antennen können dabei ohne Einschränkung mit einer konstanten Bahngeschwindigkeit oder mit einer, beispielsweise durch eine Registerwalzenanordnung, modulierten Bahngeschwindigkeit an der Messantennenanordnung der Messeinrichtung vorbeigeführt werden.

In einer bevorzugten Ausführung des erfindungsgemäßen Verfahrens ist vorgesehen, dass für jede der Antennen zumindest 50, vorzugsweise zumindest 100 Messwerte des zurücklaufenden Hochfrequenzsignals S_{rück} bestimmt und nachfolgend gemittelt werden. Zusätzlich oder alternativ ist es jedoch auch möglich, direkt durch eine entsprechende Ausgestaltung des elektrischen Messkreises das Signal, beispielsweise durch Filter, zu glätten und/oder zu mitteln.

Die als defekt ermittelten Antennen können im Rahmen der Erfindung direkt aus der Materialbahn entfernt oder beispielsweise durch einen Aufdruck oder eine Stanzung, markiert werden. Des Weiteren ist es auch möglich die Position von defekten Antennen auf der Materialbahn elektronisch in eine Steuerung abzuspeichern, wobei anhand dieser Informationen nachfolgend lediglich funktionsfähige Antennen mit einem RFID-Chip versehen werden.

Vor dem kontaktlosen Testen werden die Antennen vorzugsweise in einem Druckverfahren, beispielsweise einem Tiefdruckverfahren, mit leitfähiger Druckfarbe auf die Materialbahn aufgedruckt. Als Materialbahn kommt insbesondere polymeres Folienmaterial, vorzugsweise aus der Gruppe der Polyester, Polyamide und Polyolefine in Frage, wobei die Materialbahn typischerweise eine Schichtdicke zwischen 30 und 150 µm aufweist.

Insbesondere um eine kostengünstige Herstellung der Antennen für RFID-Etiketten zu ermöglichen, ist vorzugsweise vorgesehen, dass die Materialbahn quer zu ihrer Laufrichtung zumindest zwei Reihen von Antennen aufweist, wobei für jede Reihe jeweils zumindest eine Messantennenanordnung der Messeinrichtung vorgesehen ist. Um dabei eine gegenseitige Störung der Messantennenanordnungen untereinander zu vermeiden sind diese in Laufrichtung der Materialbahn zueinander versetzt angeordnet. Der Abstand zwischen zwei benachbarten Messantennenanordnungen beträgt dabei zweckmäßigerweise zumindest die Hälfte der Wellenlänge der Antennen. Um mit dem erfindungsgemäßen Verfahren eine möglichst hohe Genauigkeit zu erzielen muss der Spalt zwischen den Leiterbahnen der Antennen einerseits und den Messantennen andererseits möglichst konstant gehalten werden.

Die Erfindung wird im Folgenden anhand einer lediglich ein Ausführungsbeispiel darstellenden Zeichnung erläutert. Es zeigen schematisch:
- Fig. 1: ein Messsystem zum kontaktlosen Testen von auf einer Materialbahn aufgebrachten Antennen,
- Fig. 2: eine alternative Ausgestaltung des Messsystems zum kontaktlosen Testen von Antennen,
- Fig. 3: der Verlauf der von einer Messanordnung reflektierten Hochfrequenzleistung P_{rück}.

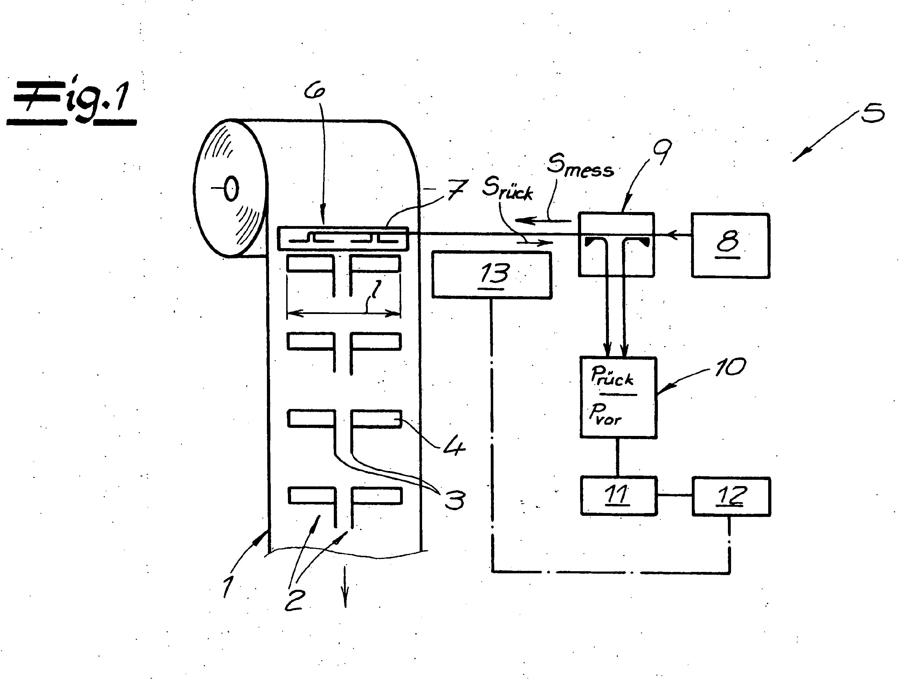

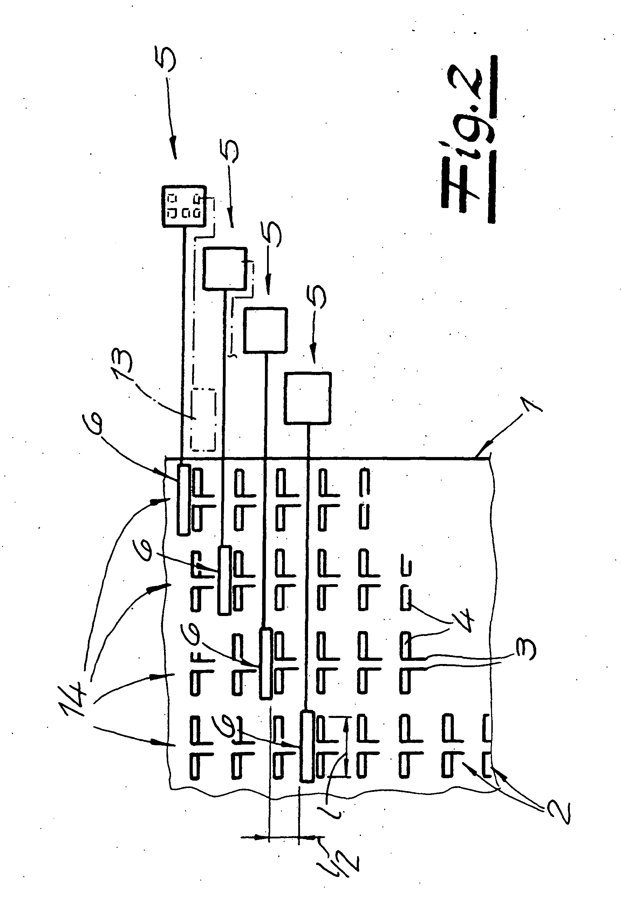

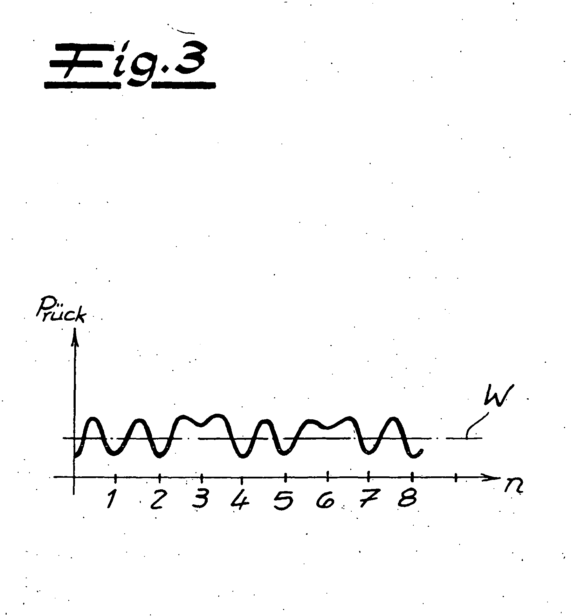

Fig. 1 zeigt eine Materialbahn 1 mit aufgebrachten Antennen 2 für RFID-Etiketten. Die Antennen 2 sind als Halbwellendipolantennen mit einer leitfähigen Druckfarbe in einem Tiefdruckverfahren auf die Materialbahn 1 aufgedrückt, die als Polymerfolie ausgebildet ist. Die Antennen 2 weisen zwei mittige Anschlussenden 3 auf, von denen sich jeweils eine rechteckigförmige Leiterbahn 4 erstreckt. Die Arbeitsfrequenz f_{A}, die beispielsweise bei 900 MHz liegen kann, ist durch die Gesamtlänge I der Antennen 2, die in etwa der halben Wellenlänge entspricht, vorgegeben. Die Materialbahn 1 mit einer Vielzahl von Antennen 2 wird einer Messeinrichtung 5 zugeführt, wobei die Antennen 2 im Bereich der Messeinrichtung 5 jeweils an einer zugeordneten Messantennenanordnung 6 der Messeinrichtung 5 vorbeigeführt werden. Die Messantennenanordnung 6 weist dabei für jede der Leiterbahnen 4 eine separate Messantenne 7 auf. Die Messantennen 7 sind von einem Sender 8 über einen Richtkoppler 9 mit einem Hochfrequenzsignal Sₘₑₛₛ beaufschlagt, dessen Frequenz fₘₑₛₛ etwa dem Doppelten der vorgegebenen Arbeitsfrequenz f_{A} der Antenne 2 entspricht. Der Richtkoppler 9 gibt ein erstes und ein zweites Messsignal aus, wobei das erste Messsignal proportional zu der Hochfrequenzleistung Pᵥₒᵣ ist, die zu der Messantennenanordnung 6 hinläuft und wobei das zweite Messsignal proportional zu der von der Messantennenanordnung reflektierten Hochfrequenzleistungen P_{rück} ist. Aus den Messsignalen wird in einem Analogdividierer 10 die Rückflussdämpfung als Quotient dieser beiden Größen ermittelt. Der ermittelte Wert für die Rückflussdämpfung wird nachfolgend auf einen Operationsverstärker 11 mit Schwellwertersetzung gegeben. Abhängig von dem Erreichen des Schwellwertes wird von einer Auswertelogik 12 bestimmt, ob die einzelnen Antennen 2 jeweils vorgegebene Herstellungstoleranzen erreichen. Zu diesem Zweck kann vorgesehen sein, dass für jede der Antennen 2 zumindest 50, vorzugsweise zumindest 100 Messwerte von der Auswertelogik 12 bestimmt und nachfolgend gemittelt werden. Die als defekt erkannten Antennen 2 werden von einer Druckvorrichtung 13 mit einem Aufdruck markiert. Im Rahmen der Erfindung liegt jedoch auch die Position der defekten Antennen 2 elektronisch in einer Prozesssteuerung zu speichern und nachfolgend nur die funktionsfähigen Antennen 2 mit einem RFID-Chip zu versehen oder die defekten Antennen 2 durch Stanzen zu markieren bzw. aus der Materialbahn 1 zu entfernen. Das erfindungsgemäße Verfahren zum kontaktlosen Testen der Antennen 2 erlaubt hohe Bahngeschwindigkeiten von mehr als 0,8 m/s und vorzugsweise mehr als 1,6 m/s. Wie in Fig. 2 dargestellt, können, insbesondere bei einer Massenfertigung, in Querrichtung der Materialbahn 1 mehrere Reihen 14 von Antennen 2 vorgesehen sein, wobei für jede der Reihen 14 eine separate Messantennenanordnung 6 vorgesehen ist. Benachbarte Messantennenanordnungen 6 sind dabei in Laufrichtung der Materialbahn 1 um zumindest eine halbe Wellenlänge (≈ l/₂) der Antennen 2 versetzt angeordnet um eine gegenseitige Störung der Messantennenanordnungen 6 untereinander zu verhindern. Jeder Messantennenanordnung 6 ist, wie in Fig. 1 dargestellt, ein Sender 8, ein Richtkoppler 9 und die dazugehörige Verstärker/Auswerte-Schaltung zugeordnet. Fig. 3 zeigt exemplarisch den zeitlichen Verlauf der von der Messantennenanordnung 6 zurückreflektierten Hochfrequenzleistung P_{rück}. Bei der Annäherung einer ersten Antenne 2 absorbiert diese einen Teil der an der Messantennenanordnung 6 bereits gestellten Leistung, wodurch der Anteil der rücklaufenden Leistung P_{rück} reduziert wird. Bei einer Resonanz zwischen der Antenne 2 und der von der Messantennenanordnung 6 angebotenen Frequenz sinkt der Betrag der rückreflektierten Leistung P_{rück} auf ein Minimum. Sofern die Antenne 2 einen Defekt, beispielsweise eine Unterbrechung durch einen Kratzer, aufweist, ist deren effektive Länge verändert und damit auch die Resonanzfrequenz verschoben, wodurch aus nur ein geringer Anteil der von der Messantennenanordnung 6 bereitgestellten Hochfrequenzleistung absorbiert wird. Der Betrag der reflektierten Hochfrequenzleistung P_{rück} bleibt so vergleichsweise hoch. Durch Setzen eines geeigneten Schwellwertes W können demnach funktionsfähige und defekte Antennen 2 unterschieden werden. Anstelle der kontinuierlichen Aufnahme eines Signals, wie es in Fig. 3 zur Verdeutlichung dargestellt ist, werden im Rahmen der Erfindung vorzugsweise für jede der Antennen 2 eine Vielzahl von einzelnen Messwerten über ein vorgegebenes Messfenster aufgenommen und nachfolgend gemittelt. Die gemittelten Werte werden dann mit einem Vorgabewert verglichen. Abhängig von dem Überschreiten des Vorgabewertes wird dann für jede Antenne 2 die Einhaltung der vorgegebenen Herstellungstoleranzen bestimmt.

## Patentansprüche

1. Verfahren zum kontaktlosen Testen von auf einer Materialbahn (1) aufgebrachten Antennen (2) für RFID-Etiketten,
wobei die Materialbahn (1) mit einer Vielzahl von Antennen (2), die als Dipolantennen aus zwei Leiterbahnen (4) mit jeweils einem unkontaktierten Anschlussende (3) gebildet sind und bei denen sich die in etwa gleich langen Leiterbahnen (4) ausgehend von den mittigen Anschlussenden (3) voneinander weg erstrecken, einer Messeinrichtung (5) zugeführt wird,
wobei die Antennen (2) im Bereich der Messeinrichtung (5) jeweils an einer zugeordneten Messantennenanordnung (6) der Messeinrichtung (5) vorbeigeführt werden,
wobei die Messantennenanordnung (6) für jede der Leiterbahnen (4) eine separate Messantenne aufweist und mit einem Hochfrequenzsignal (Sₘₑₛₛ) eines Senders (8) beaufschlagt wird, dessen Frequenz etwa dem doppelten der Arbeitsfrequenz der Antennen (2) entspricht,
wobei das von der Messantennenanordnung (6) zurücklaufende Hochfrequenzsignal (S_{rück}) bestimmt und mit Vorgabewerten verglichen wird und
wobei durch den Vergleich des zurücklaufenden Hochfrequenzsignals (S_{rück}) mit den Vorgabewerten für die einzelnen Antennen (2) jeweils die Einhaltung von Herstellungstoleranzen ermittelt wird.

2. Verfahren nach Anspruch 1, wobei das Hochfrequenzsignal von dem Sender (8) über einen Richtkoppler (9) zu der Messantennenanordnung (6) geführt wird, wobei der Richtkoppler (9) ein erstes Messsignal ausgibt, das proportional zu der Hochfrequenzleistung (Pᵥₒᵣ) ist, die zu der Messantennenanordnung (6) hinläuft und wobei der Richtkoppler (9) ein zweites Messsignal ausgibt, das proportional zu der von der Messantennenanordnung (6) reflektierten Hochfrequenzleistung (P_{rück}) ist.

3. Verfahren nach Anspruch 1 oder 2, wobei die Materialbahn (1) mit einer mittleren Bahngeschwindigkeit von mehr als 0,8 m/s, vorzugsweise mehr als 1,6 m/s an der Messeinrichtung (5) vorbeigeführt wird.

4. Verfahren nach einem der Ansprüche 1 bis 3, wobei für jede der Antennen (2) zumindest 50, vorzugsweise zumindest 100 Messwerte des zurücklaufenden Hochfrequenzsignals (S_{rück}) bestimmt und nachfolgend gemittelt werden.

5. Verfahren nach einem der Ansprüche 1 bis 4, wobei die Antennen (2), welche die Herstellungstoleranzen nicht enthalten, markiert oder entfernt werden.

6. Verfahren nach einem der Ansprüche 1 bis 5, wobei die Messantennenanordnung (6) von dem Sender (8) mit einem Hochfrequenzsignal (Sₘₑₛₛ) im UHF-Band beaufschlagt wird.

## Claims

1. A method for the non-contacting testing of antennae (2) for RFID tags affixed to a material web (1),
wherein the material web (1), with a multiplicity of antennae (2) that are formed as dipole antennae from two conducting tracks (4) with in each case a non-contacted connector end (3), and in which the approximately equally long conductor tracks (4), starting from the central connector ends (3), extend apart from one another, is conveyed to a measuring device (5),
wherein the antennae (2) in the region of the measuring device (5) are in each case directed past an assigned measuring antennae arrangement (6) of the measuring device (5),
wherein the measuring antennae arrangement (6) has a separate measuring antenna for each of the conducting tracks (4) and is supplied with a high-frequency signal (Sₘₑₛₛ) of a transmitter (8), whose frequency corresponds to approximately twice the working frequency of the antennae (2),
wherein the high-frequency signal (s_{rück}) returning from the measuring antennae arrangement (6) is determined and compared with specified values, and
wherein by the comparison of the returning high-frequency signal (s_{rück}) with the specified values for the individual antennae (2) the adherence to manufacturing tolerances is determined in each case.

2. The method according to Claim 1, wherein the high-frequency signal from the transmitter (8) is supplied via a directional coupler (9) to the measuring antennae arrangement (6), wherein the directional coupler (9) outputs a first measurement signal that is proportional to the high-frequency power (Pᵥₒᵣ) that is fed to the measuring antennae arrangement (8), and wherein the directional coupler (9) outputs a second measurement signal that is proportional to the high-frequency power (P_{rück}) that is reflected from the measuring antennae arrangement (6).

3. The method according to Claim 1 or 2, wherein the material web (1) is directed past the measuring device (5) with an average web speed of more than 0.8 m/s, preferably more than 1.6 m/s.

4. The method according to one of the Claims 1 to 3, wherein for each of the antennae (2), at least 50, preferably at least 100 measurement values of the returning high-frequency signal (s_{rück}) are determined and subsequently averaged.

5. The method according to one of the Claims 1 to 4, wherein the antennae (2) that do not adhere to the manufacturing tolerances are tagged or removed.

6. The method according to one of the Claims 1 to 5, wherein the measuring antennae arrangement (6) is supplied by the transmitter (8) with a high-frequency signal (Sₘₑₛₛ) in the UHF band.

## Revendications

1. Procédé pour tester sans contact des antennes appliquées sur une bande de matériau (1) pour des étiquettes RFID,
la bande de matériau (1) dotée d'une pluralité d'antennes (2), qui sont formées comme des antennes dipôles de deux pistes conductrices (4) dotées chacune d'une extrémité de branchement (3) non mise en contact et sur lesquelles les pistes conductrices (4) de longueur à peu près identique s'étendent l'une à partir de l'autre en partant des extrémités de branchement (3) centrales, étant amenée à un dispositif de mesure (5),
les antennes (2) étant guidées dans la zone du dispositif de mesure (5) chaque fois en passant devant un agencement d'antennes de mesure (6) attribué du dispositif de mesure (5),
l'agencement d'antennes de mesure (6) présentant une antenne de mesure séparée pour chacune des pistes conductrices (4) et étant alimenté avec un signal de haute fréquence (Sₘₑₛₛ) d'un émetteur (8), dont la fréquence correspond à peu près au double de la fréquence de travail des antennes (2),
le signal de haute fréquence (s_{rück}) revenant de l'agencement d'antennes de mesure (6) étant déterminé et comparé avec des valeurs allouées et
le respect de tolérances de fabrication étant déterminé à chaque fois par la comparaison du signal de haute fréquence (s_{rück}) revenant avec les valeurs allouées pour les antennes (2) individuelles.

2. Procédé selon la revendication 1, le signal de haute fréquence étant guidé de l'émetteur (8) à l'agencement d'antennes de mesure (6) au moyen d'un coupleur directif (9), le coupleur directif (9) émettant un premier signal de mesure qui est proportionnel à la puissance de haute fréquence (Pᵥₒᵣ), qui va à l'agencement d'antennes de mesure (6) et le coupleur directif (9) émettant un second signal de mesure qui est proportionnel à la puissance de haute fréquence (P_{rück}) réfléchie par l'agencement d'antennes de mesure (6).

3. Procédé selon la revendication 1 ou 2, la bande de matériau (1) étant guidée avec une vitesse de bande moyenne supérieure à 0,8 m/s, de préférence plus de 1,6 m/s en passant devant le dispositif de mesure (5).

4. Procédé selon l'une quelconque des revendications 1 à 3, au moins 50, de préférence au moins 100 valeurs de mesure du signal de haute fréquence (S_{rück}) revenant étant déterminées et calculées en moyenne ensuite pour chacune des antennes (2).

5. Procédé selon l'une quelconque des revendications 1 à 4, les antennes (2), qui n'incluent pas les tolérances de fabrication, étant repérées ou enlevées.

6. Procédé selon l'une quelconque des revendications 1 à 5, l'agencement d'antennes de mesure (6) étant alimenté par l'émetteur (8) avec un signal de haute fréquence (Sₘₑₛₛ) dans la bande UHF.
